# EUROPÄISCHE PATENTSCHRIFT

(11) **EP 3 010 854 B1**
(45) Veröffentlichungstag und Bekanntmachung des Hinweises auf die Patenterteilung: **05.09.2018**
(21) Anmeldenummer: 14729361.7
(22) Anmeldetag: 12.06.2014
(51) Int. Cl.: C01B 33/04, C23C 18/12, H01L 31/18, C08G 77/60, C09D 183/16, C08G 77/04

(54) **FORMULIERUNGEN UMFASSEND HYDRIDOSILANE UND HYDRIDOSILAN-OLIGOMERE, VERFAHREN ZU IHRER HERSTELLUNG UND IHRER VERWENDUNG**
FORMULATIONS CONTAINING HYDRIDOSILANES AND HYDRIDOSILANE OLIGOMERS, METHOD FOR PREPARING SAME AND USE THEREOF
FORMULATIONS COMPRENANT DES HYDRIDOSILANES ET DES OLIGOMÈRES D'HYDRIDOSILANE, LEUR PROCÉDÉ DE PRÉPARATION ET LEUR UTILISATION

(30) Priorität: 18.06.2013 DE 102013010101
(43) Veröffentlichungstag der Anmeldung: 27.04.2016
(73) Patentinhaber: Evonik Degussa GmbH, 45128 Essen (DE)
(72) Erfinder: TRAUT, Stephan, 79541 Lörrach Brombach (DE); PATZ, Matthias, 46240 Bottrop (DE); WIEBER, Stephan, 76137 Karlsruhe (DE); WÖBKENBERG, Paul Henrich, 27243 Hölingen (DE); ERZ, Joachim, 79739 Schwörstadt (DE); HESSING, Jutta, 46282 Dorsten (DE)
(86) Internationale Anmeldenummer: PCT/EP2014/062229
(87) Internationale Veröffentlichungsnummer: WO 2014/202453

(56) Entgegenhaltungen:
- WO-A2-2012/041837
- DE-A1- 2 139 155
- US-A- 6 027 705

## Beschreibung

Die vorliegende Erfindung betrifft Formulierungen umfassend mindestens ein niedermolekulares Hydridosilan und mindestens ein Hydridosilan-Oligomer, Verfahren zu ihrer Herstellung und ihrer Verwendung, insbesondere zur Herstellung Silicium-haltiger Schichten.

Hydridosilane bzw. ihre Oligomerisate sind in der Literatur als mögliche Edukte für die Erzeugung Silicium-haltiger Schichten beschrieben.

Dabei sind unter Hydridosilanen Verbindungen zu verstehen, die im Wesentlichen lediglich Silicium- und Wasserstoffatome enthalten und die weniger als 20 Siliciumatome aufweisen. Hydridosilane können prinzipiell gasförmig, flüssig oder fest sein und sind - insbesondere im Falle von Feststoffen - im Wesentlichen löslich in Lösemitteln wie Toluol oder Cyclohexan oder in flüssigen Silanen wie Cyclopentasilan. Als Beispiele seien Monosilan, Disilan, Trisilan, Cyclopentasilan und Neopentasilan genannt. Hydridosilane mit mindestens drei bzw. vier Siliciumatomen können eine lineare, verzweigte oder (ggf. bi-/poly-)cyclische Struktur mit Si-H-Bindungen aufweisen und lassen sich bevorzugt durch die jeweiligen generischen Formeln SiₙH₂ₙ₊₂ (linear bzw. verzweigt; mit n = 2 - 20), SiₙH₂ₙ (cyclisch; mit n = 3 - 20) oder SiₙH₂₍ₙ₋ᵢ₎ (bi- bzw. polycyclisch; n = 4 - 20; i = {Zahl der Cyclen} - 1) beschreiben.

Verfahren zur Herstellung von Hydridosilanen mit mindestens 3 Siliciumatomen werden z.B. in US 6,027,705 A offenbart. Ein thermisches Verfahren zur Herstellung von Oligomerisaten von Hydridosilanen offenbart WO 2011/104147 A1. Weiterhin offenbart WO 2012/041837 A2 ein Verfahren zur Herstellung höherer Hydridosilan-Verbindungen, bei dem eine niedere Hydridosilan-Verbindung in Gegenwart eines Hydridosilan-Polymers mit mindestens 500 g/mol thermisch umgesetzt wird.

Silicium-haltige Schichten können aus der Gasphase in Vakuumkammern abgeschieden werden, z. B. über PECVD. Gasphasenverfahren sind jedoch technisch aufwendig und führen oft nicht zu Schichten gewünschter Qualität. Aus diesem Grund werden Flüssigphasenverfahren zur Herstellung Silicium-haltiger Schichten oft bevorzugt.

Der Stand der Technik beschreibt verschiedene Hydridosilan-haltige Formulierungen. So offenbart z. B. US 5,866,471 A Formulierungen enthaltend Halbleiter-Precursoren, mit denen Halbleiterschichten hergestellt werden können. Die einsetzbaren Halbleiter-Precursoren umfassen auch Hydridosilane. Auch WO 2008/137811 A2 offenbart Zusammensetzungen enthaltend einen oder mehrere Halbleiter-Precursoren, die aus einer Gruppe ausgewählt werden und (Poly-)Silane umfassen. Auch US 2009/0215219 A1 offenbart ein Verfahren zur Herstellung einer Halbleiter-Schicht, bei dem eine Siliciumatom-haltige flüssige Beschichtungszusammensetzung auf ein Substrat aufgebracht wird. Die Beschichtungszusammensetzung kann ein Silan-Polymer enthalten, bei dem es sich um ein Poly-Hydridosilan handeln kann. US 2010/0197102 A1 offenbart Lösungen enthaltend eine Verbindung, bei der es sich bevorzugt um ein Silan mit vier bis neun Siliciumatomen handelt. Beschichtungszusammensetzungen enthaltend ein Polysilan werden auch in EP 1 357 154 A1 beschrieben. EP 1 640 342 A1 offenbart weiterhin Silan-Polymere mit einem gewichtsmittleren Molekulargewicht von 800 bis 5.000 g/mol, die zur Herstellung Silicium-haltiger Filme eingesetzt werden können. Auch JP 2008-270603 A und JP 09-45922 A offenbaren Beschichtungszusammensetzungen zur Herstellung Silicium-haltiger Filme, bei denen verschiedene Silicium-Verbindungen als Precursoren eingesetzt werden können. Gemische verschiedener Hydridosilan-Precursoren werden in den genannten Literaturstellen nicht offenbart.

JP 2004-134440 A offenbart Beschichtungszusammensetzungen zur Herstellung Silicium-haltiger Filme, die verschiedene Silan-Verbindungen und cyclische Silane enthalten. Auch EP 1 085 579 A1 und EP 1 087 428 A1 offenbaren Beschichtungszusammensetzungen zur Herstellung Silicium-haltiger Schichten, bei denen zwei Silicium-Precursoren eingesetzt werden. Bei diesen handelt es sich um eine cyclische Silicium-Verbindung und eine dotierte Silicium-Verbindung. JP 2000-031066 A offenbart flüssige Beschichtungszusammensetzungen enthaltend ein Hydrido-Silan der generischen Formel SiₙH₂ₙ₊₂ oder SiₙH₂ₙ oder Gemische der beiden. DE 10 2010 030 696 A1 offenbart ebenfalls flüssige Beschichtungszusammensetzungen, die Hydridosilane als Silicium-Precursoren aufweisen können.

Beschichtungszusammensetzungen enthaltend als Silicium-Precursor ausschließlich niedermolekulare Hydridosilane haben Nachteile bei der Herstellung Silicium-haltiger Schichten. Insbesondere eignen sie sich nicht für die Herstellung sehr dünner Silicium-haltiger Schichten (Schichten mit einer Dichte von max. 25 nm), da bei typischen Konvertierungstemperaturen das niedermolekulare Material verdampft, bevor es vernetzen kann. Aus diesem Grunde werden oft Beschichtungszusammensetzungen enthaltend Hydridosilan-Oligomere mit hohen Molekulargewichten eingesetzt. Diese hochmolekularen Hydridosilan-Oligomere eignen sich zwar prinzipiell zur Herstellung Silicium-haltiger Schichten, sie haben jedoch den Nachteil, sich in organischen Lösemitteln nur schlecht zu lösen, was zu Nachteilen der mit ihnen hergestellten Schichten führt. Aus diesem Grund existieren im Stand der Technik Beschichtungszusammensetzungen, die neben hochmolekularen Hydridosilan-Oligomeren auch niedermolekulare Hydridosilane aufweisen, wobei letztere als Lösungsvermittler fungieren.

Im Stand der Technik sind Beschichtungszusammensetzungen zur Herstellung Silicium-haltiger Schichten beschrieben, die ein Hydridosilan-Oligomer im Gemisch mit einem cyclischen Hydridosilan enthalten (Masuda et al., Thin Solid Films 520 (2012) 5091-5096). Entsprechende Beschichtungszusammensetzungen enthaltend ein cyclisches Hydridosilan haben jedoch den Nachteil, dass sie nur bei hohen Konzentrationen cyclischer Hydridosilane stabil sind. Bei niedrigen Konzentrationen cyclischer Hydridosilane werden die Formulierungen schnell trüb und eignen sich dann nicht zur Herstellung qualitativ hochwertiger Silicium-haltiger Schichten.

Es wurde weiterhin festgestellt, dass niedere Hydridosilane mit 3 bis 6 Siliciumatomen, insbesondere solche der Formel SiₙH₂ₙ₊₂, in Formulierungen mit Hydridosilan-Oligomeren den Nachteil haben, bei der Konvertierung nicht in den Schichtverbund eingebaut zu werden. Somit ist die Ausbeute, bezogen auf alle Silicium-haltigen Precursoren, bei Verwendung entsprechender Beschichtungszusammensetzungen, ungünstig.

Es ist somit die Aufgabe der vorliegenden Erfindung, für die Herstellung Silicium-haltiger Schichten geeignete Beschichtungszusammensetzungen bereitzustellen, die die Nachteile des Standes der Technik überwinden. Insbesondere ist es Aufgabe der vorliegenden Erfindung, stabile Beschichtungszusammensetzungen bereitzustellen, die neben dem Hydridosilan-Oligomer weitere Komponenten nur in geringen Anteilen erfordern. Weiterhin soll die weitere Komponente auch mit guten Ausbeuten in den Schichtverbund eingebaut werden.

Die vorliegende Aufgabe wird vorliegend gelöst durch die erfindungsgemäße Formulierung umfassend mindestens ein Hydridosilan und mindestens ein Hydridosilan-Oligomer, bei dem das Hydridosilan die generische Formel SiₙH₂ₙ₊₂ mit n = 7 bis 10 aufweist, und der Anteil des Hydridosilan-Oligomers, bezogen auf die Gesamtmasse an anwesendem Hydridosilan und Hydridosilan-Oligomer, 60 - 80 Gew.-% beträgt, wobei das Hydridosilan-Oligomer ein gewichtsmittleres Molekulargewicht von 200 bis 10.000 g/mol aufweist, und das Hydridosilan-Oligomer durch Oligomerisierung von nicht-cyclischem, verzweigten Hydridosilan erhalten wird.

Entsprechende Formulierungen lösen nicht nur die an die Erfindung gestellten Aufgaben, sondern eignen sich insbesondere zur Herstellung hochqualitativer, dicker Schichten mit mindestens 25 nm Dicke, insbesondere mit Dicken von 50 - 1.000 nm, aus der flüssigen Phase und benetzen im Beschichtungsprozess gängige Substrate gut.

Bei der beanspruchten Formulierung handelt es sich vorliegend um eine Zusammensetzung, die mindestens ein Hydridosilan und mindestens ein Hydridosilan-Oligomer umfasst oder aus einem Gemisch der beiden besteht. Bevorzugt ist die Formulierung flüssig, da sie so besonders gut handhabbar ist. Bevorzugt handelt es sich weiterhin bei der erfindungsgemäßen Formulierung um eine Beschichtungszusammensetzung, insbesondere für Flüssigphasen- oder CVD-Abscheidungsprozesse. Entsprechende Beschichtungszusammensetzungen haben den Vorteil, sich für die Abscheidung Silicium-haltiger Schichten, insbesondere für die genannten Prozesse, zu eignen. Ganz besonders bevorzugt ist die erfindungsgemäße Zusammensetzung eine für Flüssigphasen-Abscheidungsprozesse geeignete Beschichtungszusammensetzung.

Hydridosilane der Formel SiₙH₂ₙ₊₂ mit n = 7 bis 10 sind nicht-cyclische Hydridosilane. Die Isomere dieser Verbindungen können linear oder verzweigt sein. Bevorzugte nicht-cyclische Hydridosilane sind Octasilan (d.h. n-Octasilan, 2-Silyl-Heptasilan, 3-Silyl-Heptasilan, 4-Silyl-Heptasilan, 2,2-Disilyl-Hexasilan, 2,3-Disilyl-Hexasilan, 2,4-Disilyl-Hexasilan, 2,5-Disilyl-Hexasilan, 3,4-Disilyl-Hexasilan, 2,2,3- Trisilal-Pentasilan, 2,3,4-Trisilyl-Pentasilan, 2,3,3-Trisilyl-Pentasilan, 2,2,4- Trisilal-Pentasilan, 2,2,3,3-Tetrasilyl-Tetrasilan, 3-Disilyl-Hexasilan, 2-Silyl-3-disilyl-Pentasilan und 3-Silyl-3-disilyl-Pentasilan) und Nonasilan (d.h. n-Nonasilan, 2-Silyl-Oktasilan, 3-Silyl-Oktasilan, 4-Silyl-Oktasilan, 2,2-Disilyl-Heptasilan, 2,3-Disilyl-Heptasilan, 2,4-Disilyl-Heptasilan, 2,5-Disilyl-Heptasilan, 2,6-Disilyl-Heptasilan, 3,3-Disilyl-Heptasilan, 3,4-Disilyl-Heptasilan, 3,5-Disilyl-Heptasilan, 4,4-Disilyl-Heptasilan, 3-Disilyl-Heptasilan, 4-Disilyl-Heptasilan, 2,2,3-Trisilyl-Hexasilan, 2,2,4-Trisilyl-Hexasilan, 2,2,5-Trisilyl-Hexasilan, 2,3,3-Trisilyl-Hexasilan, 2,3,4-Trisilyl-Hexasilan, 2,3,5-Trisilyl-Hexasilan, 3,3,4-Trisilyl-Hexasilan, 3,3,5-Trisilyl-Hexasilan, 3-Disilyl-2-Silyl-Hexasilan, 4-Disilyl-2-Silyl-Hexasilan, 3-Disilyl-3-Silyl-Hexasilan, 4-Disilyl-3-Silyl-Hexasilan, 2,2,3,3-Tetrasilyl-Pentasilan, 2,2,3,4-Tetrasilyl-Pentasilan, 2,2,4,4-Tetrasilyl-Pentasilan, 2,3,3,4-Tetrasilyl-Pentasilan, 3-Disilyl-2,2-Disilyl-Pentasilan, 3-Disilyl-2,3-Disilyl-Pentasilan, 3-Disilyl-2,4-Disilyl-Pentasilan und 3,3-Disilyl-Pentasilan), deren Formulierungen zu besonders guten Ergebnissen führen. Ebenfalls bevorzugt handelt es sich bei dem Hydridosilan der genannten generischen Formel um ein verzweigtes Hydridosilan, das zu stabileren Lösungen und besseren Schichten führt als ein lineares Hydridosilan. Ganz besonders bevorzugt ist das Hydridosilan ein Gemisch von Nonasilan-Isomeren, das hergestellt werden kann über thermische Behandlung von Neopentasilan oder nach einer durch Holthausen et al. beschrieben Vorschrift (Posterpräsentation: A. Nadj, 6th European Silicon Days, 2012). Mit entsprechenden Formulierungen können die besten Ergebnisse erzielt werden.

Bei dem Hydridosilan-Oligomer handelt es sich um das Oligomerisat einer Hydridosilan-Verbindung und bevorzugt um das Oligomerisat eines Hydridosilans. Das Hydridosilan-Oligomer weist ein gewichtsmittleres Molekulargewicht von 200 bis 10.000 g/ml auf, und die erfindungsgemäße Formulierung eignet sich besonders gut eignet sich für die Herstellung Silicium-haltiger Schichten. Verfahren zur ihrer Herstellung sind dem Fachmann bekannt. Entsprechende Molekulargewichte können über Gelpermeations-Chromatographie unter Verwendung einer linearen Polystyrolsäule mit Cyclooktan als Eluent gegen Polybutadien als Referenz bestimmt werden.

Das Hydridosilan-Oligomer wird durch Oligomerisation nicht-cyclischer, verzweigter Hydridosilane erhalten. Anders als Hydridosilan-Oligomere aus cyclischen Hydridosilanen weisen diese Oligomere aufgrund des unterschiedlich ablaufenden, dissoziativen Polymerisationsmechanismus einen hohen Quervernetzungsanteil auf. Oligomere aus cylischen Hydridosilanen haben stattdessen aufgrund des ringöffnenden Reaktionsmechanismus, dem cyclische Hydridosilane unterworfen sind, wenn überhaupt, nur einen sehr geringen Quervernetzungsanteil. Entsprechende aus nicht-cyclischen Hydridosilanen hergestellte Oligomere benetzen anders als Oligomere aus cyclischen Hydridosilanen in Lösung die Substratoberfläche gut, können für die Herstellung dünner Schichten besonders gut eingesetzt werden und führen zu homogenen und glatten Oberflächen. Oligomere aus nicht-cyclischen, verzweigten Hydridosilane zeigen bessere Ergebnisse.

Ein besonders bevorzugtes Hydridosilan-Oligomer ist ein durch thermische Umsetzung einer Zusammensetzung umfassend mindestens ein nicht-cyclisches Hydridosilan mit maximal 20 Siliciumatomen in Abwesenheit eines Katalysators bei Temperaturen von < 235 °C erhältliches Oligomer. Entsprechende Hydridosilan-Oligomere und ihre Herstellung werden in WO 2011/104147 A1 beschrieben, worauf in Bezug auf die Verbindungen und ihre Herstellung Bezug genommen wird. Dieses Oligomer weist noch bessere Eigenschaften auf als die weiteren Hydridosilan-Oligomere aus nicht-cyclischen, verzweigten Hydridosilanen.

Das Hydridosilan-Oligomer kann neben Wasserstoff und Silicium noch andere Reste aufweisen. So können Vorteile der mit den Formulierungen hergestellten Schichten resultieren, wenn das Oligomer kohlenstoffhaltig ist. Entsprechende kohlenstoffhaltige Hydridosilan-Oligomere können durch Co-Oligomerisation von Hydridosilanen mit Kohlenwasserstoffen hergestellt werden. Bevorzugt handelt es sich jedoch bei dem Hydridosilan-Oligomer um eine ausschließlich Wasserstoff- und Silicium-aufweisende Verbindung, die also keine Halogen- oder Alkylreste aufweist.

Bevorzugt zur Herstellung dotierter Silicium-haltiger Schichten sind weiterhin Hydridosilan-Oligomere, die dotiert sind. Bevorzugt sind die Hydridosilan-Oligomere bor- oder phosphordotiert und entsprechende Formulierungen eignen sich zur Herstellung p- bzw. n-dotierter Siliciumschichten. Entsprechende Hydridosilan-Oligomere können durch Zugabe der entsprechenden Dotierstoffe bereits bei ihrer Herstellung erzeugt werden. Alternativ können auch bereits hergestellte, nicht dotierte Hydridosilan-Oligomere mit Stoffen ausgewählt aus der Gruppe der p-Dotanden, insbesondere der Hydroborierungsreagenzien (insbesondere B₂H₆, BH₃*THF, BEt₃, BMe₃) p-dotiert oder mit n-Dotanten (insbesondere PH₃, P₄) mittels eines energetischen Prozesses (z.B. UV-Bestrahlung oder thermische Behandlung) n-dotiert werden.

Der Anteil des bzw. der Hydridosilane beträgt bevorzugt 0,1 bis 99 Gew.-%, weiter bevorzugt 1 bis 40 Gew.-%, ganz besonders bevorzugt 1 bis 30 Gew.-% bezogen auf die Gesamtmasse der Formulierung.

Der Anteil des bzw. der Hydridosilan-Oligomere beträgt bevorzugt 0,1 bis 99 Gew.-%, weiter bevorzugt 1 bis 60 Gew.-%, ganz besonders bevorzugt 10 bis 40 Gew.-% bezogen auf die Gesamtmasse der Formulierung.

Der Anteil des Hydridosilan-Oligomers an der Formulierung beträgt 60 - 80 Gew.-% bezogen auf die Gesamtmasse an anwesendem Hydridosilan und Hydridosilan-Oligomer zur Erzielung besonders guter Ergebnisse. Bevorzugt beträgt der Anteil 40 - 99,9 Gew.-%, besonders bevorzugt 60 - 99 Gew%. Noch weiter bevorzugt beträgt der Anteil des Hydridosilan-Oligomers 60 bis unter 70 Gew.-% bezogen auf die Gesamtmasse an anwesendem Hydridosilan und Hydridosilan-Oligomer. Ebenfalls weiter bevorzugt beträgt der Anteil an Hydridosilan-Oligomer 70 - 80 Gew.-% bezogen auf die Gesamtmasse an anwesendem Hydridosilan und Hydridosilan-Oligomer.

Unterhalb von 60 Gew.-% können inhomogene, raue Schichten resultieren. Weiterhin können entsprechende Formulierungen zu Problemen führen, da sie zu dünn sein und Benetzungsprobleme bei der Beschichtung zeigen können. Dies kann zwar oft durch Variation des Lösemittelanteils und der Lösemittelzusammensetzung behoben werden, ist jedoch aufwändig.

Oberhalb von 80 Gew.-% können inhomogene, nicht geschlossene bzw. schollige Schichten resultieren und der Film im Beschichtungsprozess brechen. Weiterhin können Fehlerbilder in den Schichten resultieren ("Kometen").

Optimal ist somit ein Anteil an Hydridosilan-Oligomer in der Formulierung von 60 - 80 Gew.-%, bezogen auf die Gesamtmasse an anwesendem Hydridosilan und Hydridosilan-Oligomer.

Die erfindungsgemäße Formulierung muss kein Lösemittel enthalten. Bevorzugt weist sie jedoch mindestens ein Lösemittel auf. Enthält sie ein Lösemittel, beträgt dessen Anteil bevorzugt 0,1 bis 99 Gew.-%, weiter bevorzugt 25 bis 95 Gew.-%, ganz besonders bevorzugt 60 bis 95 Gew.-% bezogen auf die Gesamtmasse der Formulierung.

Ganz besonders bevorzugt ist eine Formulierung aufweisend 1 - 30 Gew.-% Hydridosilan, 10 - 40 Gew.-% Hydridosilan-Oligomer und 50 - 85 Gew.-% Lösemittel, bezogen auf die Gesamtmasse der Formulierung, mit der beste Ergebnisse erzielt werden können.

Bevorzugt einsetzbare Lösemittel sind die ausgewählt aus der Gruppe bestehend aus linearen, verzweigten oder cyclischen gesättigten, ungesättigten oder aromatischen Kohlenwasserstoffen mit 1 bis 12 Kohlenstoffatomen (ggf. partiell oder vollständig halogeniert), Alkoholen, Ethern, Carbonsäuren, Estern, Nitrilen, Aminen, Amiden, Sulfoxiden und Wasser. Besonders bevorzugt sind n-Pentan, n-Hexan, n-Heptan, n-Oktan, n-Dekan, Dodekan, Cyclohexan, Cyclooctan, Cyclodekan, Dicyclopentan, Benzol, Toluol, m-Xylol, p-Xylol, Mesitylen, Indan, Inden, Tetrahydronaphtalin, Decahydronaphtalin, Diethylether, Dipropylether, Ethylenglycoldimethylether, Ethylenglycoldiethylether, Ethylenglycol-methylethylether, Diethylenglycoldimethylether, Diethylenglycol-diethylether, Diethylenglycolmethylethylether, Tetrahydrofuran, p-Dioxan, Acetonitril, Dimethylformamid, Dimethylsulfoxid, Dichlormethan und Chloroform.

Die erfindungsgemäße Formulierung kann weiterhin neben dem mindestens einen Hydridosilan und dem mindestens einen Hydridosilan-Oligomer und dem oder den ggf. anwesenden Lösemitteln noch weitere Stoffe, insbesondere Dotierstoffe (bevorzugt B₂H₆, BH₃*THF, BEt₃, BMe₃, PH₃, P₄), Nanopartikel oder Additive zur Einstellung der rheologischen Eigenschaften aufweisen. Entsprechende Stoffe sind dem Fachmann bekannt.

Gegenstand der vorliegenden Erfindung ist weiterhin ein Verfahren zur Herstellung einer erfindungsgemäßen Formulierung, bei dem ein Hydridosilan der generischen Formel SiₙH₂ₙ₊₂ mit n = 7 - 10 mit einem Hydridosilan-Oligomer und ggf. einem Lösemittel vermischt wird, wobei der Anteil des Hydridosilan-Oligomers, bezogen auf die Gesamtmasse an anwesendem Hydridosilan und Hydridosilan-Oligomer, 60 - 80 Gew.-% beträgt.

Es können Silicium-haltige Schichten hergestellt werden, wobei die erfindungsgemäße Formulierung, insbesondere die Beschichtungszusammensetzung, aus der Gasphase oder der flüssigen Phase auf ein unbeschichtetes oder vorbeschichtetes Substrat aufgebracht und thermisch und/oder mit elektromagnetischer Strahlung in eine Silicium-haltige Schicht konvertiert wird.

Es können eine Vielzahl von Substraten eingesetzt werden. Bevorzugt sind Substrate bestehend aus Glas, Quarzglas, Graphit, Metall, Silicium oder bestehend aus einer auf einem hitzeverträglichen Träger befindlichen Silicium-, Indiumzinnoxid-, ZnO:F-, ZnO:Al- oder SnO₂:F-Schicht. Bevorzugte Metalle sind Aluminium, Edelstahl, Cr-Stahl, Titan, Chrom bzw. Molybdän. Ferner können bei Wahl geeigneter Konvertierungsbedingungen auch Kunststofffolien (z. B. aus PEEK, PEN, PET oder Polyimiden) eingesetzt werden.

Das Aufbringen der Formulierung erfolgt bevorzugt über ein Gas- oder Flüssigphasen-Beschichtungsverfahren ausgewählt aus Druckverfahren (insbesondere Flexo/Gravur-Druck, Nano- bzw. Mikroimprint, Inkjet-Druck, Offset-Druck, reverse Offset-Druck, digitalem Offset-Druck und Siebdruck), Sprühverfahren, aerosol assisted chemical vapour deposition, direct liquid injection chemical vapour deposition, Rotationsbeschichtungsverfahren ("Spin-coating"), Tauchverfahren ("Dip-coating") und Verfahren ausgewählt aus Meniscus Coating, Slit Coating, Slot-Die Coating, und Curtain Coating. Von den zuvor genannten Verfahren sind dabei aerosol assisted chemical vapour deposition und direct liquid injection chemical vapour deposition den Gasphasenverfahren zuzuordnen. Bevorzugt erfolgt die Aufbringung über ein Flüssigphasen-Beschichtungsverfahren.

Nach der Aufbringung der Formulierung kann bevorzugt eine Vorvernetzung über eine UV-Bestrahlung des flüssigen Filmes auf dem Substrat durchgeführt werden, nach der der noch flüssige Film quervernetzte Precursoranteile aufweist.

Nach Aufbringen und ggf. Vorvernetzen der Formulierung kann das beschichtete Substrat weiterhin bevorzugt vor der Konvertierung getrocknet werden, um ggf. anwesendes Lösemittel zu entfernen. Entsprechende Maßnahmen und Bedingungen hierfür sind dem Fachmann bekannt. Um ausschließlich leicht flüchtige Formulierungsbestandteile zu entfernen, sollte im Falle einer thermischen Trocknung die Heiztemperatur weniger als 200 °C betragen.

Die thermische Konvertierung erfolgt bevorzugt bei Temperaturen von 200 - 1000 °C, vorzugsweise 250 - 750 °C, insbesondere bevorzugt 300 - 700 °C. Thermische Konvertierungszeiten betragen bevorzugt zwischen 0,1 ms und 360 min. Die Konvertierungszeit beträgt weiter bevorzugt zwischen 0,1 ms und 10 min, besonders bevorzugt zwischen 1 s und 120 s.

Entsprechende schnelle energetische Prozessführungen können zum Beispiel durch den Einsatz einer IR-Lampe, einer Heizplatte, einem Ofen, einer Blitzlampe, eines Plasmas mit geeigneter Gaszusammensetzung, einer RTP-Anlage, einer Mikrowellenanlage oder einer Elektronenstrahlbehandlung (wenn erforderlich, im jeweils vorgeheizten bzw. warmgelaufenen Zustand) erfolgen.

Alternativ bzw. ergänzend kann eine Konvertierung durch Bestrahlung mit elektromagnetischer Strahlung, insbesondere mit UV-Licht, erfolgen. Die Konvertierungszeit kann dabei bevorzugt zwischen 1 s und 360 min betragen.

Während der oder im Anschluss an die Konvertierung kann weiterhin bevorzugt eine Anreicherung der Silicium-haltigen Schichten mit Wasserstoff durchgeführt werden. Dabei handelt es sich um eine sogenannte "Wasserstoffpassivierung", die Defekte im Material ausgleicht, und z. B. mit reaktivem Wasserstoff nach dem Hotwire Verfahren, mit einem wasserstoffhaltigen Plasma (remote oder direkt; im Vakuum oder unter Atmosphärendruck) oder mittels Coronabehandlung oder einer Elektronenstrahlbehandlung unter Zufuhr von Wasserstoff erfolgen kann. Weiterhin kann auch der bereits erwähnte Trocknungs- und/oder der Konvertierungsschritt in mit Wasserstoff angereicherter Atmosphäre durchgeführt werden, so dass das Material von vornherein wasserstoffreich ist.

Zur Herstellung Siliciumoxid-haltiger Schichten kann weiterhin Aufbringen, Vorvernetzen, Trocknen und/oder Konvertieren unter oxidierenden Bedingungen durchgeführt werden. Wie oxidierende Bedingungen eingestellt werden, ist dem Fachmann bekannt.

Zur Herstellung voll- oder teilkristalliner Silicium-haltiger Schichten kann die Schicht nach dem Konvertieren mittels Eintrag von thermischer Energie, elektromagnetischer Strahlung und/oder Partikelbeschuss kristallisiert werden. Methoden hierzu sind dem Fachmann bekannt.

Das beschriebene Verfahren zur Herstellung Silicium-haltiger Schichten kann weiterhin bezogen auf ein Substrat gleichzeitig oder zeitlich hintereinander mehrfach durchgeführt werden (gleichzeitiges oder aufeinanderfolgendes Abscheiden, wobei die resultierenden Filme teilweise oder komplett übereinanderliegen). Ein solches Verfahren zur Herstellung von Mehrschichtsystemen eignet sich bevorzugt zur Herstellung von Systemen aufgebaut aus intrinsischen (d. h. nicht dotierten) und dotierten Schichten, die z. B. essentiell für den Aufbau von Solarzellen sind. Besonders bevorzugt eignet sich das Verfahren zur Herstellung von Mehrschichtsystemen zur optimalen Passivierung oder Vermeidung von Defekten an der Grenzfläche zum Substrat, wenn auf das Substrat eine dünne intrinsische (d. h. nicht dotierte) Silicium-haltige Schicht und dann eine zum Substrat gegensätzlich dotierte Schicht aufgebracht wird. In diesem Fall wird somit auf ein dotiertes Substrat zunächst eine im Wesentlichen Dotierstoff-freie Formulierung und anschließend auf diese eine einen in Bezug auf das Substrat entgegengesetzten Dotierstoff aufweisende Formulierung aufgebracht. Außerdem kann das Substrat beidseitig beschichtet werden.

Die erfindungsgemäß herstellbaren Hydridosilan-Formulierungen eignen sich für eine Vielzahl von Verwendungen. Besonders gut eignen sie sich - für sich genommen oder zusammen mit anderen Formulierungen - zur Herstellung elektronischer oder optoelektronischer Bauteilschichten. Gegenstand der Erfindung ist somit auch die Verwendung der erfindungsgemäßen Hydridosilan-Formulierungen zur Erzeugung optoelektronischer oder elektronischer Bauteilschichten. Weiterhin ist ein Gegenstand der Erfindung die Verwendung der erfindungsgemäßen Hydridosilan-Formulierungen zur Erzeugung elektronischer und optoelektronischer Bauteile. Bevorzugt eignen sich die nach dem erfindungsgemäßen Verfahren erhältlichen Hydridosilan-Formulierungen zur Herstellung ladungstransportierender Komponenten in optoelektronischen oder elektronischen Bauteilen. Die nach dem erfindungsgemäßen Verfahren erhältlichen Hydridosilan-Formulierungen eignen sich weiterhin zur Herstellung Silicium-haltiger Schichten.

Insbesondere eignen sich die erfindungsgemäßen Formulierungen und das erfindungsgemäße Verfahren zur Herstellung der folgenden Schichten bzw. Bauteile:
- Heteroemitter Solarzellen
- HIT (heterojunction with intrinsic thin layer) Solarzellen
- Selective Emitter Solarzellen
- Back contact Solarzellen
- Feldeffekt Transistoren, Dünnschichttransistoren
- Dielektrische Schichten in mikroelektronischen Bauteilen
- Oberflächenpassivierung von Halbleitermaterialien
- Herstellung von Quantum Dots enthaltenden Schichten und Bauteilen
- Barrieren gegen Diffusion von Bestandteilen der Umgebung durch Schichten,
- Barriereschichten zur thermischen Entkopplung von Ober- und Unterseite von Schichten

### Beispiele:

### Beispiel 1

Auf EagleXG Glas wird eine Mischung aus 0,21 g Nonasilan, 0,29 g Hydridosilan-Oligomer (entsprechend 58 Gew.-% bezogen auf die Gesamtmasse an Hydridosilan und Hydridosilan-Oligomer) aus Neopentasilan (Mw ∼ 2200 g/mol), 0,37 g Cyclooktan und 0,87 g Toluol bei 3000 U/min, 6000 U/min, und 9000 U/min beschichtet und anschließend bei 500 °C / 60 s konvertiert. Die resultierenden Schichtdicken liegen zwischen 48 - 74 nm.

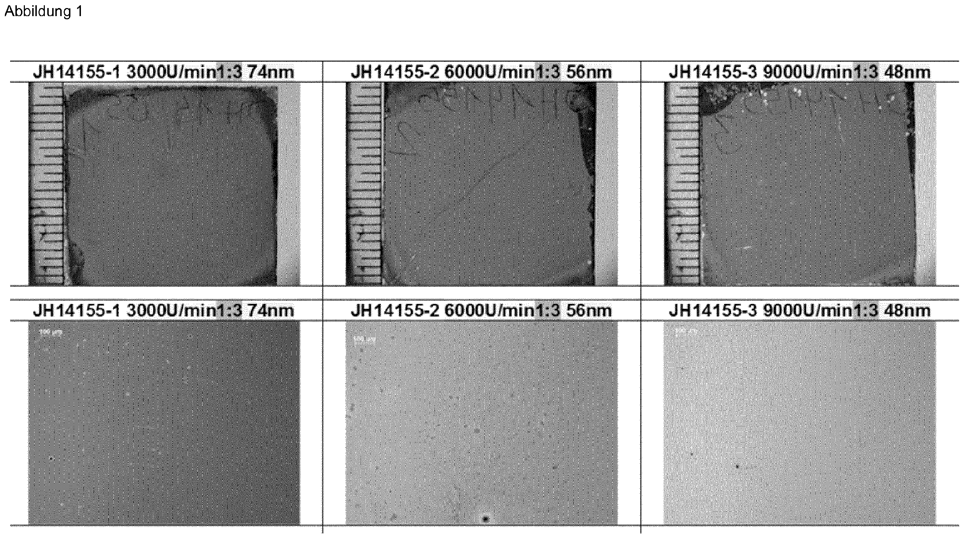

Die prinzipielle Eignung der relativ dünnen Beschichtungsformulierung für Halbleiteranwendungen geht aus Abbildung 1 hervor. Den dort gezeigten Fotos und Mikroskop-Aufnahmen kann jedoch entnommen werden, dass die resultierenden Beschichtungen relativ inhomogen und rau sind.

### Beispiel 2

Auf einem EagleXG Glas wird eine Mischung aus 0,25g undotiertem Hydridosilan-Oligomer (entsprechend 62,5 Gew.-% bezogen auf die Gesamtmasse an Hydridosilan und Hydridosilan-Oligomer) aus Neopentasilan (M_{w} ∼2300 g) und 0,150g Nonasilan in 0,180 g Cyclooktan und 0,420 g Toluol bei 6000 U/min beschichtet und anschließend bei 500 °C / 60s konvertiert. Die resultierende Schichtdicke beträgt 113 nm.

Die resultierenden Schichten sind homogen und glatt.

### Beispiel 3

Auf EagleXG Glas wird eine Mischung aus 0,17 g Nonasilan, 0,33 g Hydridosilan-Oligomer (entsprechend 66 Gew.-% bezogen auf die Gesamtmasse an Hydridosilan und Hydridosilan-Oligomer) aus Neopentasilan (M_{w} ∼ 2200 g/mol), 0,87 g Toluol und 0,37 g Cyclooctan bei 3000 U/min, 6000 U/min und 9000 U/min beschichtet und anschließend bei 500 °C / 60 s konvertiert. Die resultierenden Schichtdicken liegen im Bereich zwischen 66 - 104 nm.

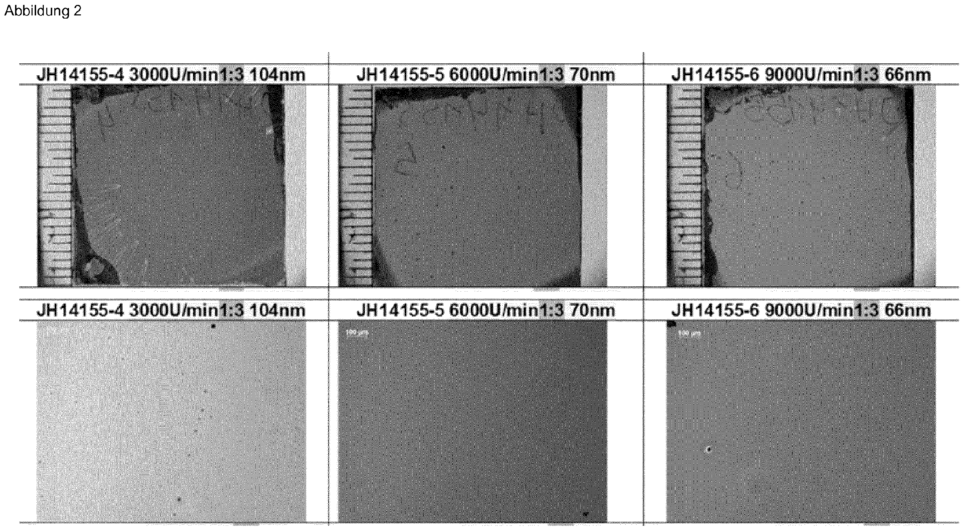

Die resultierenden Schichten sind, wie auch aus den Fotos und Mikroskop-Aufnahmen gemäß Abbildung 2 hervorgeht, homogen und glatt.

### Beispiel 4

Auf EagleXG Glas wird eine Mischung aus 0,13 g Nonasilan, 0,37 g Hydridosilan-Oligomer (entsprechend 74 Gew.-% bezogen auf die Gesamtmasse an Hydridosilan und Hydridosilan-Oligomer) aus Neopentasilan (M_{w} ∼ 2200 g/mol), 0,87 g Toluol und 0,37 g Cyclooctan bei 3000 U/min, 6000 U/min und 9000 U/min beschichtet und anschließend bei 500 °C / 60 s konvertiert. Die resultierenden Schichtdicken liegen im Bereich zwischen 90 - 140 nm.

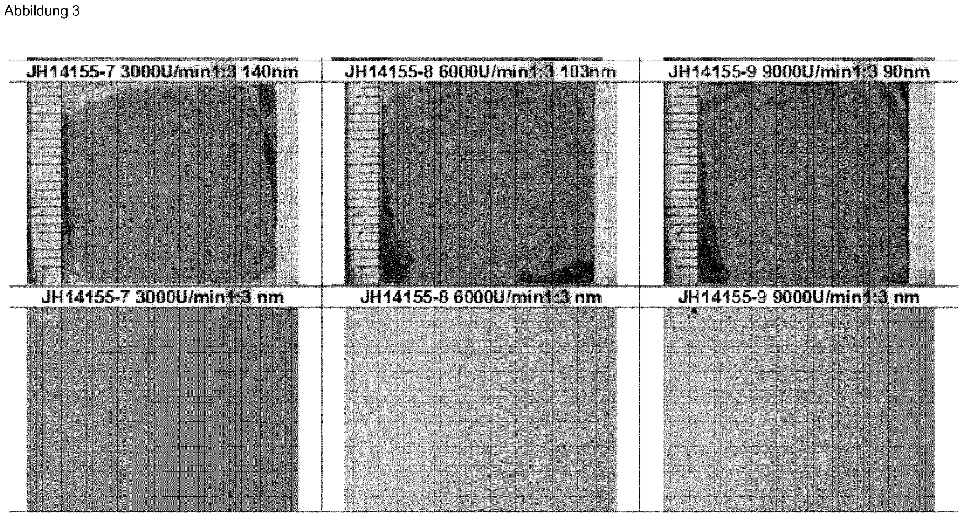

Die resultierenden Schichten sind, wie auch aus den Fotos und Mikroskop-Aufnahmen gemäß Abbildung 3 hervorgeht, homogen und glatt.

### Beispiel 5

Auf einem EagleXG Glas wird eine Mischung aus 0,25g undotiertem Hydridosilan-Oligomer (entsprechend 76,9 Gew.-% bezogen auf die Gesamtmasse an Hydridosilan und Hydridosilan-Oligomer) aus Neopentasilan (M_{w} ∼2300 g) und 0,075 g Nonasilan in 0,158 g Cyclooktan und 0,368 g Toluol bei 6000 U/min beschichtet und anschließend bei 500 °C / 60s konvertiert. Die resultierende Schichtdicke beträgt 130 nm.

Die resultierenden Schichten sind homogen und glatt.

### Beispiel 6

Auf EagleXG Glas wird eine Mischung aus 0,08 g Nonasilan, 0,42 g Hydridosilan-Oligomer (84 Gew.-% bezogen auf die Gesamtmasse an Hydridosilan und Hydridosilan-Oligomer) aus Neopentasilan (M_{w} ∼ 2000 g/mol), 0,24 g Cyclooktan und 0,96 g Toluol bei 4500 U/min und 6000 U/min beschichtet und anschließend bei 500 °C / 60 s konvertiert. Die resultierenden Schichtdicken betragen 164 nm bzw 150 nm.

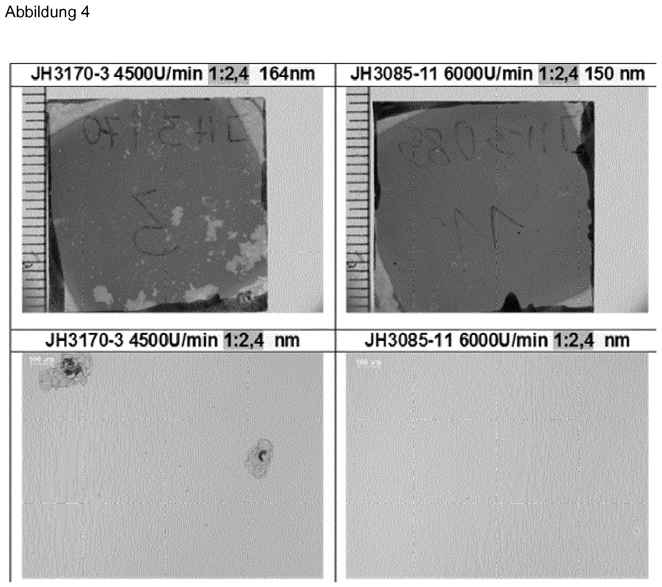

Die prinzipielle Eignung der relativ dünnen Beschichtungsformulierung für Halbleiteranwendungen geht aus Abbildung 4 hervor. Den dort gezeigten Fotos und Mikroskop-Aufnahmen kann jedoch entnommen werden, dass die resultierenden Beschichtungen relativ inhomogen und nicht geschlossen bzw. schollig sind. Weiterhin sind Fehlerbilder in der Schicht zu erkennen.

### Vergleichsbeispiel 1

Auf einem EagleXG Glas wird eine Mischung aus 0,25g undotiertem Hydridosilan-Oligomer aus Neopentasilan (M_{w} ∼2300g) in 0,203 g Cyclooktan und 0,472 g Toluol bei 6000 U/min beschichtet und anschließend bei 500 °C / 60s konvertiert. Die resultierende Schichtdicke beträgt 102 nm. Die resultierenden Schichten sind jedoch nachteilig.

### Vergleichsbeispiel 2

Auf einem EagleXG Glas wird eine Mischung aus 0,25g undotiertem Hydridosilan-Oligomer aus Neopentasilan (M_{w}∼2300g) und 0,150g Neopentasilan in 0,180 g Cyclooktan und 0,420 g Toluol bei 6000 U/min beschichtet und anschließend bei 500 °C / 60s konvertiert. Die resultierende Schichtdicke beträgt 99 nm. Die Ausbeute ist somit ungünstiger, als wenn ein Hydridosilan der generischen Formel SiₙH₂ₙ₊₂ mit n = 7 - 10 beigemengt wird.

### Vergleichsbeispiel 3

Auf einem EagleXG Glas wird eine Mischung aus 0,27 g Nonasilan, 0,03 g Hydridosilan-Oligomer (10 Gew.-% bezogen auf die Gesamtmasse an Hydridosilan und Hydridosilan-Oligomer) aus Neopentasilan (M_{w} ∼ 2200 g/mol) und 0,30 g Toluol bei 1000 U/min, 2000 U/min, 3000 U/min und 6000 U/min beschichtet und anschließend bei 500 °C / 60 s konvertiert. Die resultierenden Schichten sind inhomogen, nicht flächendeckend und weisen viele Fehler auf.

### Vergleichsbeispiel 4

Auf einem EagleXG Glas wird eine Mischung aus 0,27 g Nonasilan, 0,03 g Hydridosilan-Oligomer (10 Gew.-% bezogen auf die Gesamtmasse an Hydridosilan und Hydridosilan-Oligomer) aus Neopentasilan (M_{w} ∼ 2200 g/mol), 0,48 g Toluol und 0,20 g Cyclooctan bei 1000 U/min, 2000 U/min, 3000 U/min und 6000 U/min beschichtet und anschließend bei 500 °C / 60 s konvertiert. Die resultierenden Schichten sind inhomogen, nicht flächendeckend und weisen viele Fehler auf.

## Patentansprüche

1. Formulierung umfassend mindestens ein Hydridosilan und mindestens ein Hydridosilan-Oligomer,
**dadurch gekennzeichnet,**
**dass** das Hydridosilan die generische Formel SiₙH₂ₙ₊₂ mit n = 7 - 10 aufweist und, dass der Anteil des Hydridosilan-Oligomers, bezogen auf die Gesamtmasse an anwesendem Hydridosilan und Hydridosilan-Oligomer, 60 - 80 Gew.-% beträgt, wobei das Hydridosilan-Oligomer ein gewichtsmittleres Molekulargewicht von 200 bis 10.000 g/mol aufweist, und das Hydridosilan-Oligomer durch Oligomerisierung von nicht-cyclischem, verzweigten Hydridosilan erhalten wird.

2. Formulierung nach Anspruch 1,
**dadurch gekennzeichnet,**
**dass** das Hydridosilan ein Octasilan- oder Nonasilan-Isomer ist.

3. Formulierung nach Anspruch 1 oder 2,
**dadurch gekennzeichnet,**
**dass** das Hydridosilan ein verzweigtes Hydridosilan ist.

4. Formulierung nach einem der vorhergehenden Ansprüche,
**dadurch gekennzeichnet,**
**dass** das Hydridosilan-Oligomer durch thermische Umsetzung einer Zusammensetzung umfassend mindestens ein nicht-cyclisches Hydridosilan mit maximal 20 Siliciumatomen in Abwesenheit eines Katalysators bei Temperaturen von kleiner 235 °C erhältlich ist.

5. Formulierung nach einem der vorhergehenden Ansprüche,
**dadurch gekennzeichnet,**
**dass** das Hydridosilan-Oligomer kohlenstoffhaltig ist.

6. Formulierung nach einem der vorhergehenden Ansprüche,
**dadurch gekennzeichnet,**
**dass** das Hydridosilan-Oligomer dotiert ist.

7. Formulierung nach einem der vorhergehenden Ansprüche,
**dadurch gekennzeichnet,**
**dass** der Anteil des mindestens einen Hydridosilans 1 bis 40 Gew.-% bezogen auf die Gesamtmasse der Formulierung beträgt.

8. Formulierung nach einem der vorhergehenden Ansprüche,
**dadurch gekennzeichnet,**
**dass** der Anteil des mindestens einen Hydridosilan-Oligomers 1 bis 60 Gew.-% bezogen auf die Gesamtmasse der Formulierung beträgt.

9. Formulierung nach einem der vorhergehenden Ansprüche,
**dadurch gekennzeichnet,**
**dass** sie mindestens ein Lösemittel aufweist.

10. Formulierung nach Anspruch 9,
**dadurch gekennzeichnet,**
**dass** der Anteil des Lösemittels 25 bis 95 Gew.-% bezogen auf die Gesamtmasse der Formulierung beträgt.

11. Formulierung nach Anspruch 9 oder 10,
**dadurch gekennzeichnet,**
**dass** sie 1 - 30 Gew.-% Hydridosilan, 10 - 40 Gew.-% Hydridosilan-Oligomer und 50 - 85 Gew.-% Lösemittel, bezogen auf die Gesamtmasse der Formulierung, aufweist.

12. Verfahren zur Herstellung einer Formulierung umfassend mindestens ein Hydridosilan und mindestens ein Hydridosilan-Oligomer, wobei das Hydridosilan die generische Formel SiₙH₂ₙ₊₂ mit n = 7 - 10 aufweist und der Anteil des Hydridosilan-Oligomers, bezogen auf die Gesamtmasse an anwesendem Hydridosilan und Hydridosilan-Oligomer, 60 - 80 Gew.-% beträgt, **dadurch gekennzeichnet, dass** ein Hydridosilan der generischen Formel SiₙH₂ₙ₊₂ mit n = 7 - 10 mit einem Hydridosilan-Oligomer und ggf. einem Lösemittel vermischt wird.

13. Verwendung einer Formulierung nach einem der Ansprüche 1 bis 11 für die Herstellung Silicium-haltiger Schichten.

14. Verwendung einer Formulierung nach einem der Ansprüche 1 bis 11 für die Herstellung elektronischer oder optoelektronischer Schichten.

15. Verwendung einer Formulierung nach einem der Ansprüche 1 bis 11 für die Herstellung elektronischer oder optoelektronischer Bauteile.

16. Verwendung einer Formulierung umfassend mindestens ein Hydridosilan und mindestens ein Hydridosilan-Oligomer, wobei das Hydridosilan die generische Formel SiₙH₂ₙ₊₂ mit n = 7 - 10 aufweist und der Anteil des Hydridosilan-Oligomers, bezogen auf die Gesamtmasse an anwesendem Hydridosilan und Hydridosilan-Oligomer, 60 - 80 Gew.-% beträgt, für die Herstellung Silicium-haltiger Schichten.

17. Verwendung einer Formulierung umfassend mindestens ein Hydridosilan und mindestens ein Hydridosilan-Oligomer, wobei das Hydridosilan die generische Formel SiₙH₂ₙ₊₂ mit n = 7 - 10 aufweist und der Anteil des Hydridosilan-Oligomers, bezogen auf die Gesamtmasse an anwesendem Hydridosilan und Hydridosilan-Oligomer, 60 - 80 Gew.-% beträgt, für die Herstellung elektronischer oder optoelektronischer Schichten.

18. Verwendung einer Formulierung umfassend mindestens ein Hydridosilan und mindestens ein Hydridosilan-Oligomer, wobei das Hydridosilan die generische Formel SiₙH₂ₙ₊₂ mit n = 7 - 10 aufweist und der Anteil des Hydridosilan-Oligomers, bezogen auf die Gesamtmasse an anwesendem Hydridosilan und Hydridosilan-Oligomer, 60 - 80 Gew.-% beträgt für die Herstellung elektronischer oder optoelektronischer Bauteile.

## Claims

1. Formulation comprising at least one hydridosilane and at least one hydridosilane oligomer,
**characterized in that**
the hydridosilane has the generic formula SiₙH₂ₙ₊₂ with n = 7-10, and **in that** the proportion of the hydridosilane oligomer, based on the total mass of hydridosilane and hydridosilane oligomer present, is 60-80% by weight, wherein the hydridosilane oligomer has a weight-average molecular weight of 200 to 10 000 g/mol and the hydridosilane oligomer is obtained by oligomerization of noncyclic branched hydridosilane.

2. Formulation according to Claim 1,
**characterized in that**
the hydridosilane is an octasilane or nonasilane isomer.

3. Formulation according to Claim 1 or 2,
**characterized in that**
the hydridosilane is a branched hydridosilane.

4. Formulation according to any of the preceding claims,
**characterized in that**
the hydridosilane oligomer is obtainable by thermal conversion of a composition comprising at least one noncyclic hydridosilane having not more than 20 silicon atoms in the absence of a catalyst at temperatures of less than 235°C.

5. Formulation according to any of the preceding claims,
**characterized in that**
the hydridosilane oligomer contains carbon.

6. Formulation according to any of the preceding claims,
**characterized in that**
the hydridosilane oligomer has been doped.

7. Formulation according to any of the preceding claims,
**characterized in that**
the proportion of the at least one hydridosilane is 1 to 40% by weight based on the total mass of the formulation.

8. Formulation according to any of the preceding claims,
**characterized in that**
the proportion of the at least one hydridosilane oligomer is 1 to 60% by weight based on the total mass of the formulation.

9. Formulation according to any of the preceding claims,
**characterized in that**
it includes at least one solvent.

10. Formulation according to Claim 9,
**characterized in that**
the proportion of the solvent is 25 to 95% by weight based on the total mass of the formulation.

11. Formulation according to Claim 9 or 10,
**characterized in that**
it includes 1-30% by weight of hydridosilane, 10-40% by weight of hydridosilane oligomer and 50-85% by weight of solvent, based on the total mass of the formulation.

12. Process for preparing a formulation comprising at least one hydridosilane and at least one hydridosilane oligomer, wherein the hydridosilane has the generic formula SiₙH₂ₙ₊₂ with n = 7-10 and the proportion of the hydroidsilane oligomer, based on the total mass of hydridosilane and hydridosilane oligomer present, is 60-80% by weight, **characterized in that** a hydridosilane of the generic formula SiₙH₂ₙ₊₂ with n = 7-10 is mixed with a hydridosilane oligomer and optionally a solvent.

13. Use of a formulation according to any of Claims 1 to 11 for the production of silicon-containing layers.

14. Use of a formulation according to any of Claims 1 to 11 for the production of electronic or optoelectronic layers.

15. Use of a formulation according to any of Claims 1 to 11 for the production of electronic or optoelectronic components.

16. Use of a formulation comprising at least one hydridosilane and at least one hydridosilane oligomer, wherein the hydridosilane has the generic formula SiₙH₂ₙ₊₂ with n = 7-10 and the proportion of the hydridosilane oligomer, based on the total mass of hydridosilane and hydridosilane oligomer present, is 60-80% by weight, for the production of silicon-containing layers.

17. Use of a formulation comprising at least one hydridosilane and at least one hydridosilane oligomer, wherein the hydridosilane has the generic formula SiₙH₂ₙ₊₂ with n = 7-10 and the proportion of the hydridosilane oligomer, based on the total mass of hydridosilane and hydridosilane oligomer present, is 60-80% by weight, for the production of electronic or optoelectronic layers.

18. Use of a formulation comprising at least one hydridosilane and at least one hydridosilane oligomer, wherein the hydridosilane has the generic formula SiₙH₂ₙ₊₂ with n = 7-10 and the proportion of the hydridosilane oligomer, based on the total mass of hydridosilane and hydridosilane oligomer present, is 60-80% by weight, for the production of electronic or optoelectronic components.

## Revendications

1. Formulation comprenant au moins un hydridosilane et au moins un oligomère d'hydridosilane, **caractérisée en ce que** l'hydridosilane présente la formule générique SiₙH₂ₙ₊₂ dans laquelle n = 7-10 et **en ce que** la proportion d'oligomère d'hydridosilane, par rapport à la masse totale de l'hydridosilane et de l'oligomère d'hydridosilane présents, est de 60-80% en poids, l'oligomère d'hydridosilane présentant un poids moléculaire moyen en poids de 200 à 10.000 g/mole et l'oligomère d'hydridosilane étant obtenu par oligomérisation d'hydridosilane non cyclique, ramifié.

2. Formulation selon la revendication 1, **caractérisée en ce que** l'hydridosilane est un isomère d'octasilane ou de nonasilane.

3. Formulation selon la revendication 1 ou 2, **caractérisée en ce que** l'hydridosilane est un hydridosilane ramifié.

4. Formulation selon l'une quelconque des revendications précédentes, **caractérisée en ce que** l'oligomère d'hydridosilane peut être obtenu par transformation thermique d'une composition comprenant au moins un hydridosilane non cyclique présentant au maximum 20 atomes de silicium en l'absence d'un catalyseur à des températures inférieures à 235°C.

5. Formulation selon l'une quelconque des revendications précédentes, **caractérisée en ce que** l'oligomère d'hydridosilane contient du carbone.

6. Formulation selon l'une quelconque des revendications précédentes, **caractérisée en ce que** l'oligomère d'hydridosilane est dopé.

7. Formulation selon l'une quelconque des revendications précédentes, **caractérisée en ce que** la proportion dudit au moins un hydridosilane est de 1 à 40% en poids par rapport à la masse totale de la formulation.

8. Formulation selon l'une quelconque des revendications précédentes, **caractérisée en ce que** la proportion dudit au moins un oligomère d'hydridosilane est de 1 à 60% en poids par rapport à la masse totale de la formulation.

9. Formulation selon l'une quelconque des revendications précédentes, **caractérisée en ce qu'**elle présente au moins un solvant.

10. Formulation selon la revendication 9, **caractérisée en ce que** la proportion de solvant est de 25 à 95% en poids par rapport à la masse totale de la formulation.

11. Formulation selon la revendication 9 ou 10, **caractérisée en ce qu'**elle présente 1-30% en poids d'hydridosilane, 10-40% en poids d'oligomère d'hydridosilane et 50-85% en poids de solvant, par rapport à la masse totale de la formulation.

12. Procédé pour la préparation d'une formulation comprenant au moins un hydridosilane et au moins un oligomère d'hydridosilane, l'hydridosilane présentant la formule générique SiₙH₂ₙ₊₂ dans laquelle n = 7-10 et la proportion d'oligomère d'hydridosilane, par rapport à la masse totale de l'hydridosilane et de l'oligomère d'hydridosilane présents, étant de 60-80% en poids, **caractérisé en ce qu'**on mélange un hydridosilane de formule générique SiₙH₂ₙ₊₂ dans laquelle n = 7-10 avec un oligomère d'hydridosilane et le cas échéant un solvant.

13. Utilisation d'une formulation selon l'une quelconque des revendications 1 à 11 pour la fabrication de couches contenant du silicium.

14. Utilisation d'une formulation selon l'une quelconque des revendications 1 à 11 pour la fabrication de couches électroniques ou optoélectroniques.

15. Utilisation d'une formulation selon l'une quelconque des revendications 1 à 11 pour la fabrication de pièces électroniques ou optoélectroniques.

16. Utilisation d'une formulation comprenant au moins un hydridosilane et au moins un oligomère d'hydridosilane, l'hydridosilane présentant la formule générique SiₙH₂ₙ₊₂ dans laquelle n = 7-10 et la proportion d'oligomère d'hydridosilane, par rapport à la masse totale de l'hydridosilane et de l'oligomère d'hydridosilane présents, étant de 60-80% en poids, pour la fabrication de couches contenant du silicium.

17. Utilisation d'une formulation comprenant au moins un hydridosilane et au moins un oligomère d'hydridosilane, l'hydridosilane présentant la formule générique SiₙH₂ₙ₊₂ dans laquelle n = 7-10 et la proportion d'oligomère d'hydridosilane, par rapport à la masse totale de l'hydridosilane et de l'oligomère d'hydridosilane présents, étant de 60-80% en poids, pour la fabrication de couches électroniques ou optoélectroniques.

18. Utilisation d'une formulation comprenant au moins un hydridosilane et au moins un oligomère d'hydridosilane, l'hydridosilane présentant la formule générique SiₙH₂ₙ₊₂ dans laquelle n = 7-10 et la proportion d'oligomère d'hydridosilane, par rapport à la masse totale de l'hydridosilane et de l'oligomère d'hydridosilane présents, étant de 60-80% en poids, pour la fabrication de pièces électroniques ou optoélectroniques.
